(19) Europäisches Patentamt
European Patent Office
Office européen des brevets

(11) Veröffentlichungsnummer: **0 236 696 B1**

# (12) EUROPÄISCHE PATENTSCHRIFT

(45) Veröffentlichungstag der Patentschrift: **04.03.92**

(51) Int. Cl.5: **G11C 16/00**, G11C 11/22

(21) Anmeldenummer: **87100679.7**

(22) Anmeldetag: **20.01.87**

## (54) Nichtflüchtiger elektronischer Speicher.

(30) Priorität: **31.01.86 DE 3602887**

(43) Veröffentlichungstag der Anmeldung:
**16.09.87 Patentblatt 87/38**

(45) Bekanntmachung des Hinweises auf die Patenterteilung:
**04.03.92 Patentblatt 92/10**

(84) Benannte Vertragsstaaten:
**BE CH DE FR GB IT LI NL SE**

(56) Entgegenhaltungen:
**EP-A- 0 086 991**
**EP-A- 0 166 938**
**US-A- 4 271 487**

**FERROELECTRICS, Band 3, Nr. 1,November 1971, New York, US J.C. CRAWFORD "Piezoelectric response of a ferroelectric memory array" Seiten 139-146**

**Bell Laboratories Record (33), September 1955, Seiten 335-342**

(73) Patentinhaber: **BAYER AG**
**W-5090 Leverkusen 1 Bayerwerk(DE)**

(72) Erfinder: **Pott, Richard, Dr.**
**Im Rosengarten 4**
**W-5090 Leverkusen 3(DE)**
Erfinder: **Eiling, Aloys, Dr.**
**Schmiedestrasse 12**
**W-4630 Bochum 6(DE)**
Erfinder: **Kämpf,Günther,Prof.Dr.**
**Wöhlerstrasse 4**
**W-4150 Krefeld(DE)**

EP 0 236 696 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung geht aus von einem elektronischen Halbleiterspeicher mit Wort- und Bitleitungen zur wahlweisen Adressierung des Speicherzellen (RAM). Ein solcher Speicher vereint in sich die Eigenschaften der großen Speicherdichte, einer großen Schreib/Lesegeschwindigkeit sowie des wahlfreien Zugriffs auf die Speicherzellen. Allerdings ist die gespeicherte Information nicht permanent vorhanden, d.h. der Speicher muß zur Erhaltung des Informationszustandes periodisch aktiviert bzw. zumindest mit einer Spannung beaufschlagt werden.

Die heute üblichen Halbleiterspeicher lassen sich in zwei große Gruppen aufteilen:

1. Die flüchtigen RAM's (Random Access Memory) wie SRAM (Static RAM) und DRAM (Dynamic RAM), die bei hoher Speicherdichte (1 Mb), sehr schneller Zugriffszeit beim Schreib- bzw. Leseprozeß (< 100 ns) und wahlfreiem Zugriff hauptsächlich als Arbeitsspeicher von Rechnern Verwendung finden und
2. die nichtflüchtigen ROM's (Read Only Memory) wie EPROM (Electrically Programmable ROM) und EEPROM (Electrically Erasable PROM), die bei vergleichsweise deutlich höheren Anschaffungspreisen, bei relativ geringer Speicherdichte und wesentlich geringeren Schreibgeschwindigkeiten auch bei einem Ausfall oder Abschalten der Versorgungsspannung im Gegensatz zu den RAM's ihre Information beibehalten.

In der Vergangenheit wurde als eine Lösung für einen nichtflüchtigen Speicher mit dem Eigenschaftsspektrum eines RAM die Kombination von CMOSRAM's (CMOS auf Grund des geringen Leistungsverbrauchs) mit einer Batterie für die Notstromversorgung propagiert. Diese Vorgehensweise stellt aber nur eine Notlösung dar, da die Batterien eine begrenzte Lebensdauer besitzen, das Gewicht des Systems erhöhen, zusätzlichen Platz erfordern und insbesondere bei kritischen (z. B. sicherheitstechnischen oder militärischen) Anwendungen eine nicht ausreichende Zuverlässigkeit aufweisen.

Eine weitere Lösung, die seit Anfang der achtziger Jahre existiert, ist das sogenannte NVRAM. Lösungen dieser Art werden in US 42 71 487 und EP 86 991 A2 beschrieben. Das NVRAM besitzt die Vorzüge beider Gruppen durch die Kombination von RAM-Zellen mit nichtflüchtigen Speicherzellen. Bei dem Speicherbaustein gemäß EP 86 991 besteht eine Speicherzelle jeweils aus einem flüchtigen SRAM-Speicherelement und aus einem nichtflüchtigen Speicherelement, das auf einem Dual Gate Feldeffekt-Transistor mit einem Floating Gate und einer separaten Steuerelektrode beruht. Das Potential des Floating Gate wird mittels Stromfluß durch eine sogenannte DEIS-Isolatorschicht gesteuert, die sich zwischen dem Floating Gate und der separaten Steuerelektrode befindet.

Das NVRAM ist allerdings mit dem großen Nachteil der weitaus größten Anschaffungskosten aller Speicherbausteine behaftet. Läßt man die Kosten und einen im Vergleich zu den RAM's erhöhten Platzbedarf einmal außer Acht, so sind die NVRAM's die idealen Speicherbausteine, da sie die hohen Schreib- und Lesegeschwindigkeiten der RAM's mit der Nichtflüchtigkeit der ROM's in kombinierter Form aufweisen.

Üblicherweise wird in einem NVRAM als RAM-Bestandteil ein SRAM eingesetzt, so daß für jedes Bit zwei Zellen mit insgesamt neun Bauelementen vorgesehen werden müssen (sechs für SRAM,eines für EEPROM und zwei weitere Auswahltransistoren). Damit besitzt ein konventionelles NVRAM pro Einheitsfläche nur ca. 10 % der Speicherkapazität eines DRAM's, was entscheidend für den Kostennachteil ist. Ein weiterer (je nach Anwendungsfall aber weniger gravierende) Nachteil ist die begrenzte Schreibzykluszahl des nichtflüchtigen Speicherbereiches. Wertet man alle diese Argumente, so wäre ein nichtflüchtiges DRAM ideal. Gelingt die Entwicklung eines derartigen nichtflüchtigen DRAM's, würden automatisch alle anderen Halbleiterspeichertypen und in vielen Fällen auch die heute als Massenspeicher eingesetzten Magnetspeicher (z.B. Floppy Disk) überflüssig.

Speicher auf Basis elektrisch polarisierbarer Schichten wurden seit Anfang der fünfziger Jahre zuerst in Analogie zu Magnetspeichern entwickelt (W.J. Merz, J.R. Anderson, Bell Laboratories Record 33, 335-342 (1955)). Anfang der siebziger Jahre beschrieb dann Crawford (J.C. Crawford, Ferroelectrics 3, 139-146 (1972)) eine ferroelektrische Speicheranordnung, die vergleichsweise kompatibel zu den damaligen Halbleiterspeichern war. Ähnlich wie bei Merz und Anderson wurden bei diesem Speicher Elektrodenstreifen auf der Ober- und Unterseite einer keramischen ferroelektrischen Schicht (PZT) um 90° gegeneinander gedreht aufgedampft. Information konnte gespeichert werden, indem durch Anlegen einer Spannung an entsprechende Elektroden auf Ober- und Unterseite (entsprechend der Zeilen- und Spaltenadressierung bei Halbleiterspeichern) der Bereich im Kreuzungspunkt dieser Elektroden polarisiert wurde. Der Ausleseprozeß kann dann beispielsweise durch piezo- oder pyroelektrische Aktivierung bestimmter Speicherbereiche oder durch zerstörendes Auslesen erfolgen. Ein spezieller piezoelektrischer bzw. pyroelektrischer Ein- bzw. Ausleseprozeß unter Verwendung einer remanent elektrisch polarisierten Polymerschicht wird in EP A2 166 938 beschrieben. Der Vorteil eines derartigen Speichers im Vergleich zu den üblichen Si-Speichern liegt in

der potentiell größeren Speicherdichte. Allerdings müssen zu diesem Zweck sehr große Anforderungen bezüglich Schaltgeschwindigkeit, Ermüdungsfreiheit, rechteckige Hysteresekurve usw. an die ferroelektrische Schicht gestellt werden. Darüber hinaus stellte sich die Peripherie, d.h. die für das Einschreiben und Auslesen der Information benötigte Ansteuerelektronik als relativ komplex und zeitaufwendig heraus. Folgerichtig wurde Ende der siebziger Jahre der Vorschlag unterbreitet, ein ferroelektrisches Speicherelement direkt auf bzw. mit einem in Halbleitertechnik gefertigten Ansteuerungsbaustein zu integrieren (R.C.Cook, US Patent 4 149 302 (1979)). Die grundsätzliche oben beschriebene Problematik der ferroelektrischen Speicher bzgl. Schaltgeschwindigkeit, Ermüdungsfreiheit, Rechteckigkeit der Hysteresekurve usw. wird dadurch aber nicht umgangen, da die Speicherfähigkeit dieses integrierten Bauteins ausschließlich auf dem ferroelektrischen Effekt beruht. Darüberhinaus ist das als ferroelektrische Speicherschicht vorgeschlagene KNO3 in einer Halbleiterfertigung bedingt durch das Problem der Kontamination nicht oder nur sehr schwer beherschbar. Insgesamt führten diese Probleme dazu, daß bisher ferroelektrische Speicher das Entwicklungsstadium noch nicht verlassen konnten. Andere interessante nichtflüchtige Speicher auf Basis ferroelektrischer Schichten wurden ebenfalls schon sehr früh diskutiert (I.M.Ross, US-Patent 2 791 760 (1959)), wobei die ferroelektrische Schicht die Stelle des Gate-Oxids eines Feldeffekttransistors (FET) einnimmt und über die remanente Polarisierung der Zustand des Transistors bleibend gesteuert werden kann. Diese sogenannten FEFET's (FerroElectric FET) konnten sich aber bisher auch noch nicht durchsetzen, obwohl sie potentiell sehr attraktives nichtflüchtiges Speicherelement darstellen würden.

Der Erfindung liegt nun die Aufgabe zugrunde, durch die Kombination eines DRAM's oder auch SRAM's mit einem nichtflüchtigen Speicher auf Basis einer elektrisch polarisierbaren Schicht einen Speicher zu entwicklen, der die Vorzüge der RAM's mit der Nichtflüchtigkeit eines derartigen Speichers in einem einzigen integrierten Speicherbaustein in sich vereint.

Diese Aufgabe wird ausgehend von einem Halbleiterspeicherbaustein (RAM) in Verbindung mit einem Permanentspeicher erfindungsgemäß dadurch gelöst, daß der Permanentspeicher durch eine elektrisch polarisierbare vorzugsweise ferroelektrische Schicht gebildet wird, die innerhalb eines monolithischen Bausteins in der dritten Dimension auf dem RAM integriert und derart mit ihm verbunden ist, daß aufgrund eines STORE-bzw. RECALL-Befehls die im RAM-Speicherbereich vorhandene Information permanent durch Polung ausgewählter Bereiche in der elektrisch polarisierbaren vorzugsweise ferroelektrischen Schicht gespeichert bzw. ausgelesen und in den RAM-Speicherbereich zurückübertragen wird.

Vorzugsweise ist auf dem RAM mit Wort- und Bitleitungen zur wahlweisen Adressierung der Speicherzellen eine elektrisch polarisierbare, vorzugsweise ferroelektrische Schicht aufgebracht, die an ihrer Ober- und Unterseite ebenfalls mit Wort- bzw. Bitleitungen in Form von Streifenelektroden versehen ist. Dabei bildet das Streifenelektrodensystem an der Unterseite gleichzeitig das der Oberfläche zugewandte Wort- bzw. Bitleitungssystem des RAM oder ist elektrisch mit ihm verbunden, so daß jeder Halbleiterspeicherzelle eine nichtflüchtige, elektrisch polarisierbare, bzw. ferroelektrische Speicherzelle eindeutig zugeordnet ist. Die vorzugsweise ferroelektrische Schicht erfüllt hier die Funktion des zweiten permanenten Speichers, der in der dritten Dimension auf dem RAM integriert ist und zusammen mit dem RAM den neuartigen integrierten nichtflüchtigen Speicherbaustein bildet.

Spezielle Ausführungsformen und Weiterentwicklungen sind in den Unteransprüchen 2 bis 7 beschrieben.

Dieser neue Speicherbaustein, den man als FERAM bezeichnen könnte (ferroelektrischer RAM), besteht somit aus zwei Speicherbereichen, wobei der erste Speicherbereich dem flüchtigen RAM zugeordnet ist und der zweite Speicherbereich dem nichtflüchtigen Speicher auf der Basis der elektrisch polarisierbaren ferroelektrischen Schicht. Der FERAM kombiniert zwei Speichertechnologien in einem einzigen Baustein. Im Normalbetrieb ist bei dem FERAM nur der erste Speicherbereich aktiviert, d.h. der FERAM arbeitet wie ein konventionelles RAM (DRAM oder SRAM) und besitzt damit auch das gewünschte Eigenschaftsspektrum der RAM's bzgl. Ein-/Auslesegeschwindigkeit, freier Adressierbarkeit und Speicherdichte. Nur auf Grund bestimmter Vorkommnisse wird die im ersten Speicherbereich vorhandene Information in den zweiten Speicherbereich transferiert. Dies geschieht ähnlich wie bei den NVRAM's z.B. lediglich beim Abschalten des Rechners, bei Stromausfall oder auf Grund eines besonderen STORE-Befehls. Ebenso kann die im zweiten Speicherbereich permanent abgelegte Information z.B. beim Wiedereinschalten der Stromversorgung oder auf Grund eines besonderen RECALL Befehls in den erstens Speicherbereich, den RAM Teil, transferiert werden.

Der Halbleiterspeicher besteht hierbei aus einem nahezu kompletten konventionellen RAM auf NMOS- oder CMOS Basis, d.h. die zur Herstellung heutiger RAM's üblichen Herstellungsprozesse können für den Halbleiterspeicher nahezu vollständig übernommen werden. Im wesentlichen entfällt nur der letzte für die Passivierung des Dies durchzuführende Prozeßschritt. Die je nach Prozeßtechnologie auf der Oberfläche aufgebrachte Wort- oder Bitleitung findet dann Verwendung als untere Streifenelektrode des nichtflüchtigen

ferroelektrischen Speicherbereichs. Alternativ kann auch das der Oberfläche zugewandte Wort/Bitleitungssystem über Kontaktstege mit dem an der Unterseite der ferroelektrischen Schicht aufgebrachten Streifenelektrodensystem elektrisch verbunden sein.

Für das Aufbringen der ferroelektrischen Speicherschicht des zweiten Speichers existieren nun prinzipiell zwei Möglichkeiten.

Die auf Grund der gefalteten Architektur der Bit/Wortleitungen normalerweise auf dem Halbleiterspeicher vorhandenen Unebenheiten werden dadurch beseitigt, daß die Oberfläche des RAM mittels einer Passivierungsschicht eingeebnet wird und darauf die ferroelektrische Schicht gebracht wird. Es stehen dann nur wenige ausgewählte Bereiche der Wort/Bitleitung in direktem Kontakt mit dieser Schicht. Die andere Alternative besteht darin, daß die erwähnten Unebenheiten nicht beseitigt, sondern die ferroelektrische Schicht unmittelbar auf das Wort/Bitleitungssystem aufgebracht wird. Im weiteren Vorgehen existieren nun zwei weitere Alternativen. Entweder wird die Oberseite der ferroelektrischen Schicht durch entsprechende Planarisierungsschritte mittels eines inerten Materials eingeebnet oder die ferroelektrische Schicht wird so dick aufgebracht, daß eine ausreichende Planarität vorhanden ist wobei die zum Ein/Auslesen notwendige Schichtdicke durch entsprechende Ätzung eingestellt wird.

Die elektrisch polarisierbare Schicht wird durch geeignete Maßnahmen wie Aufdampfen, Sputtern, CVD (Chemical Vapor Deposition) usw. im Fall anorganisch elektrisch polarisierbarer Schichten oder durch vorzugsweise Spin Coaten im Fall organisch polarisierbarer Schichten aufgebracht. Anwendbar ist aber auch die Langmuir Blodgett Technik für das Aufbringen molekularer elektrisch polarisierbarer Schichten.

Diese Beschichtungstechniken sind bei der Herstellung von Halbleiterbauelementen üblich und werden z.B. beschrieben von P.O.Hagan, W.J.Daughton in Circuits Manufacturing 18, 71 (1978) und ferner in einem Beitrag von G.G.Roberts, Insulating Films on Semiconductors, pg. 56-67, herausgegeben von M.Schulz und G.Penzel, Springer Verlag Berlin, Heidelberg, New York 1981.

Auf diese elektrisch polarisierbare ferroelektrische Schicht wird dann wiederum mittels eines geeigneten Standardprozeßschrittes (z.B. Photolack, Belichtung, Entwickeln, Ätzen, Aufdampfen oder Sputtern oder CVD von Metall (Al) oder Siliziden die für das Ein/Auslesen notwendige obere Streifenelektrode aufgebracht, die aber auf Grund der oben angesprochenen Unebenheiten nicht zwingend um 90 gegenüber der unteren Streifenelektrode (Bit/Wortleitung) gedreht sein muß. Der Halbleiterspeicher und der ferroelektrische Speicher gehen fließend ineinander über. Dies bedeutet, daß der mittlere Flächenbedarf eines FERAM's identisch mit dem des zugrundeliegenden RAM's ist.

Als elektrisch polarisierbare Schichten werden im anorganischen Fall vorzugsweise Ferroelektrika wie Triglycinsulfat (TGS), Bariumtitanat ($BaTiO_3$), Blei/Zirkontitanat (PLZT), Wismuttitanat ($Bi_4Ti_3O_{12}$) usw. verwendet. Als organische Schichten werden vorzugsweise Polymere mit leicht polarisierbaren Atomen eingesetzt wie beispielsweise Polyolefine mit Fluoratomen wie etwa das Polyvinylidenfluorid (PVDF) oder Polymere mit stark polarisierbaren Endgruppen wie etwa das Polyvinylidencyanid (PVCN). Die gegebenenfalls notwendige Optimierung dieser elektrisch polarisierbaren Schichten kann durch Copolymerisate von PVDF mit $PVF_3$, TrFE oder Abmischungen (Blends) mit Polymethylmethacrylat (PMMA) oder Copolymere von PVCN mit Polyvinylacetat u.a. erfolgen. Elektrisch polarisierbare Langmuir Blodgett Filme setzten sich vorzugsweise aus Substanzen mit folgenden Strukturformeln zusammen:

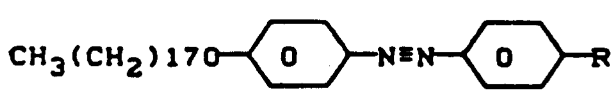

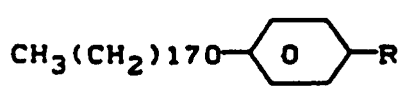

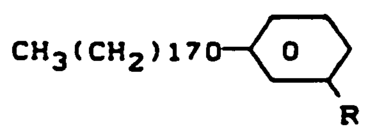

wobei die Endgruppe R = OH, CN, $NO_3$, COOH, $SO_2NH_2$,$SO_2N(C_2H_5)_2$,

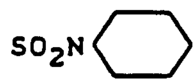

sein kann.

Mit dem erfindungsgemäßen Speicherbaustein werden folgende Vorteile gegenüber den heutigen NVRAM's erzielt:

- - der FERAM ist ein nichtflüchtiger Speicher mit DRAM Eigenschaften bzgl. Speicherdichte, Schreib/Lese-Geschwindigkeit und freier Adressierbarkeit, wobei die spezifische Speicherkapazität um einen Faktor 10 größer als bei heutigen NVRAM's ist
- - dadurch bedingt sind die Herstellungskosten weitaus geringer als bei den NVRAM's
- - die nichtflüchtige Speicherzyklenzahl ist im Vergleich zu den NVRAM's nicht begrenzt.

Im Vergleich zu einem Speicher auf rein ferroelektrischer Basis sind die Anforderungen an das Material bzgl. Schaltzeit, Rechteckigkeit der Hysteresekurve usw. wesentlich unkritischer. Zudem ist die Kompatibilität zur heutigen Speichergeneration gewahrt.

Im folgenden wird die Erfindung anhand von Zeichnungen und Ausführungsbeispielen näher erläutert. Es zeigen

Fig.1 einen Querschnitt durch eine Speicherzelle eines dynamischen Halbleiterspeichers (DRAM) auf NMOS Basis mit der zugeordneten aufintegrierten ferroelektrischen Speicherzelle

Fig. 2 eine zu Fig.1 analog augebaute Speicherzelle, wobei aber die ferroelektrische Schicht unmittelbar (ohne vorhergehende Planarisierung) auf den Halbleiterspeicher aufgebracht ist

Fig.3 eine alternative Ausführung der Speichereinheit nach Fig.1, bei der das Wort/Bitleitungssystem an der Unterseite der ferroelektrischen Schicht über Kontaktstege mit dem Wort/Bitleitungssystem an der Oberfläche der RAM-Speicherzelle verbunden ist

Fig.4 das Ersatzschaltbild einer Speicherzelle nach Fig.1 bis Fig.3

Das in Fig.1 dargestellte Speicherelement ist in NMOS Technik aufgebaut. In das p-dotierte Si-Substrat 1 sind an der Oberfläche n-dotierte Bereiche 2, 3 implantiert, die mit einer SiO2-Schicht (Gate Oxid) 4 abgedeckt sind. Die n-dotierten Zonen bilden zusammen mit der Gateelektrode 5 den Auswahltransistor 6 für die Aktivierung des Speicherelementes. Das eigentliche Speicherelement besteht aus dem am linken Bildrand angedeuteten, in das Substrat 1 implantierten Kondensator 7. Dabei ist die untere Elektrode des Kondensators mit dem n-Kanal 3 verbunden. Die andere Elektrode des Speicherkondensators 7 ist die Poly-Wortleitung 8a. Am anderen Ende der Speicherzelle ist der n-Kanal 2 des Auswahltransistors 6 mit der Metall-Bitleitung 9 kontaktiert. Die Gates 5 der Auswahltransistoren bilden die andere Wortleitung 8b für den Speicherkondensator 7. Die Wortleitungen 8a, 8b sind orhthogonal (senkrecht zur Zeichenebene) zu den in Längsrichtung verlaufenden Bitleitungen 9 angeordnet. Durch Anwahl eines bestimmten Auswahltransistors 6 über die Wortleitung 8b kann zusammen mit einer vorgegebenen Bitleitung 9 jeder gewünschte Speicherkondensator 7 mit Hilfe bekannter Schaltungstechniken adressiert werden. Die Poly-Wortleitungen 8a, 8b bilden also zusammen mit den Bitleitungen 9 eine Matrix zur Adressierung der Speicherelemente.

Die auf dem Speicherbaustein verbleibenden Unebenheiten werden mit inerten Material 10 geglättet, das gleichzeitig zur Passivierung dienen kann. Als Material 10 kann beispielsweise SiO2, Si3N4, SiOxNy, Polyimid verwendet werden. Zur Erzielung der Oberflächenglättung wird nach dem Auftrag der Schicht 10 typischerweise ein ( in der Fig. nicht gezeigter) Resist dick durch Spin-Coaten aufgetragen, der anschließend durch Ätzen bis zur Freilegung der Ursprungsstruktur wieder abgetragen wird. Hierbei wird eine Ätztechnik verwendet, für die sowohl der Resist als auch das inerte Material dieselbe Ätzrate aufweist (z.B. Ion Beam Milling unter bestimmten Winkeln). Auf diese derart vorbereitete Oberfläche wird das ferroelektrische Material 11 aufgebracht. Zur Vermeidung von Kontaminationsproblemen wird vorzugsweise ein organisches Ferroelektrikum wie Polyvinylidenfluorid (PVdF) oder ein Copolymeres wie PVdF/TrFE (TrFE Trifluoräthylen) verwendet. An der Oberseite der ferroelektrischen Speicherschicht sind parallel zu den Poly-Wortleitungen 8a, 8b verlaufende Streifenelektroden 12 aufgedampft. Die Streifenelektrode 12 bildet zusammen mit der an der Unterseite der ferroelektrischen Schicht 11 vorbeigeführten Bitleitung 9 eine ferroelektrische Speicherzelle 13. Der ferroelektrische Speicher ist also sozusagen als Backup-Speicher auf die Halbleiteroberfläche aufintegriert.

Im Gegensatz zu dem flüchtigen Halbleiterspeicher A (siehe Fig.4) kann die Information in dem ferroelektrischen Speicher B permanent niedergelegt werden. Fig.2 zeigt eine alternative Ausführung des kombinierten ferroelektrischen Halbleiterspeichers (FERAM). Für diese AUsführung liegt der gleiche Halbleiterspeicher zugrunde wie in Fig.1. Im Gegensatz dazu ist aber die ferroelektrische Speicherschicht direkt auf die Bitleitungen 9 aufgebracht. Die Unebenheiten auf der Oberfläche des ferroelektrischen Speichers

werden wieder durch eine inerte Passivierungsschicht nach dem oben beschriebenen Verfahren ausgeglichen. Auf die geglättete Oberfläche werden dann die oberen Streifenelektroden aufgebracht.

In beiden Fällen (nach Fig.1 und Fig.2) bildet das auf der Halbleiteroberfläche oben aufliegende Bitleitungssystem 9 gleichzeitig das untere Streifenelektrodensystem des ferroelektrischen Speichers. Dies stellt jedoch keine zwingende Voraussetzung dar. Vielmehr kann, wie in Fig,3 gezeigt, das Bitleitungssystem 9 über Kontaktstege 14 mit dem unteren Streifenelektrodensuystem 15 des ferroelektrischen Speichers verbunden werden.

1. Ausführungsbeispiel

PVdF wird in DMF (Dimethylformamid) unter leichtem Erwärmen in Lösung gebracht. Von uns verwendet wurden Lösungen mit einem Volumenprozentanteil von kleiner 10% typischerweise 1%. Die derart hergestellten Lösungen werden mit einem handelsüblichen Spin Coater (CONVAC 1001) auf den vorbereiteten Wafer aufgeschleudert. Bei einer gewünschten Schichtdicke von ca. 0,1 µm wird je nach Viskosität der Lösung mit einer typischen Umdrehungszahl von einigen hundert bis einigen tausend Umdrehungen/ Minute gearbeitet. Der derart beschichtete Wafer wird anschließend typischerweise 60 Minuten zwischen 40 und 260 C in einem Trockenschrank getempert. Vorzugsweise wird bei einer Temperatur zwischen 180 und 220 C getempert. Die Dicke des PVdF Films wurde mit einem Ellipsometer (Gaertner Scientific Corporation) und auch kapazitiv überprüft. Es wurden Dicken zwischen 0,03 µm und 1,5 µm bestimmt, wobei bei einer Dicke von typischerweise 0,1 µm die Dickenschwankung bei einem 4-Zoll Wafer kleiner als 10 % gefunden wurde. Die Oberflächenrauhigkeit Ra wurde mit Hilfe eines Tastschnittgerätes (Fa. Sloan Technology Corporation) kleiner als 0,02 µm bestimmt. Da die derart hergestellte PVdF Speicherschicht in einer ferroelektrisch unzureichenden Phase vorliegt, wird anschließend mittels Koronapolung im Bereich der unteren Streifenelektrode, die auf Masse gelegt wird, die erwünschte ferroelektrisch aktive Phase I (auch b genannt) eingestellt. Zu Charakterisierungszwecken wurde diese Schicht abgelöst und mittels IR-Spektroskopie als Phase I identifiziert.

2. Ausführungsbeispiel

Ein Copolymeres von PVdF/TrFE der Zusammensetzung 60/40 bzw. 75/25 wurde unter leichtem Erwärmen in DMF und in Aceton in Lösung gebracht. Typischerweise wurde mit einem Volumenprozentanteil von kleiner 10 % gearbeitet. Die Lösung wird dann mit dem Spin-Coater auf den vorbereiteten planarisierten Wafer geschleudert und anschließend direkt getempert. Bei den in DMF gelösten Proben wurde mit einer Tempertemperatur von großer 100 C gearbeitet, wobei vorzugsweise eine Temperatur zwischen 140 und 220 C eingestellt wurde. Bei den in Aceton gelösten Proben wurde bei einer Temperatur kleiner 180 C getempert , wobei vorzugsweise die Temperatur zwischen 60 und 140 C zu liegen kommt. Die Temperzeit beträgt in beiden Fällen typishcerweise eine Stunde. Die von der Viskosität der Ausgangslösungen und der eingestellten Umdrehungsfrequenz des Spin-Coaters abhängigen Schichtdicken wurden zwischen 0,02 µm und 2 µm bestimmt. Die Oberflächenrauhigkeit war bei einer Schichtdicke von typisch 0,1 µm kleiner als 0,02 µm und die Dickenschwankung war typisch kleiner als 10 %.

Die für das weitere Vorgehen wie Aufdampfen der oberen Streifenelektrode und Kontaktierung notwendige Ätzung der PVdF resp. PVdF/TrFE Schicht wird naßchemisch durch das entsprechende Lösungsmittel realisiert. Möglich sind aber auch Standard-Trockenätzprozesse.

Im folgenden wird die Wirkungsweise des kombinierten ferroelektrischen Halbleiterspeichers (FERAM) anhand von Fig.4 beschrieben werden. Insbesondere wird der Schreib/Leseprozeß im nichtflüchtigen ferroelektrischen Speicherbereich B diskutiert. Hierbei wird ausschließlich auf den in der Speicherzelle ablaufenden Vorgang eingegangen, d.h. die zur unterschiedlichen Adressierung des Halbleiter RAM A und des ferroelektrischen Speichers B notwendigen Schaltungen werden nicht näher erläutert. Sie sind zudem ähnlich wie bei den NVRAM's aufbaubar und entsprechen dem Stand der Technik.

Grundsätzlich muß zwischen den in beiden Speicherbereichen verlaufenden Schreib/Leseprozessen unterschieden werden. Da der Schreib/Leseprozeß im flüchtigen Speicherbereich A dem Stand der Technik entspricht, wird er hier nicht weiter diskutiert.

Wird nun mittels eines STORE Befehls, der aufgrund eines Zusammenbruchs der Versorgungsspanung oder eines expliziten Software-Befehls entsteht, der Speicherbereich B adressiert, so wird die im Speicherbereich A zu diesem Zeitpunkt vorhandene Information folgendermaßen in den Speicherbereich $\beta$ übernommen, wobei wir uns ohne Beschränkung der Allgemeinheit auf eine einzige Speicherzelle konzentrieren (siehe Fig.4). Die im Ladungsspeicher 7 des Speicherbereiches A vorhandene Information wird durch die Aktivierung der Wortleitung 8b des Auswahltransistors 6 mittels der entsprechenden Bitleitung 9 dem

Abtastund Auffrischverstärker zugeführt. Kurz danach wird die Adressierung der Wortleitung 8b auf die obere Streifenelektrode 12 umgelegt, so daß mittels der aktivierten Bitleitung 9 bzw. der unteren Streifenelektrode 15 und der oberen Streifenelektrode 12 durch Anlegen einer Spannung U die im Kreuzungsbereich beider Leitungen vorhandene elektrisch polarisierbare Schicht 11 bleibend polarisiert wird. Diese Spannung U muß natürlich so groß gewählt werden, daß die Polarisierung tatsächlich erfolgt, d.h. U/d (d ist die Dicke der elektrisch polarisierbaren Schicht) muß größer als die entsprechende Materialkoerzitivkraftfeldstärcke sein. Vorzugsweise wird zur Vermeidung der Umpolarisierung benachbarter Speicherzellen (bedingt durch parasitäre Koppelkapazitäten) mit +- U/2 gearbeitet. Dies bedeutet beispielsweise, daß bei anorganischen Ferroelektrika mit typischen Koerzitivfeldstärken von 0,1 V/µm bei einer Spannung U = 5 V eine Schichtdicke von ca. 30 µm eingestellt werden muß. Bei organischen Ferroelektrika, wie PVdF oder PVdF/TrFE, hingegen beträgt die Koerzitivfeldstärke typischerweise 50 V/µm, so daß Schichtdicken von kleiner 0,1 µm angestrebt werden. Überraschend wurde gefunden, daß die Koerzitivfeldstärke zudem insbesondere bei Schichtdicken kleiner 0,5 µm dickenabhängig ist, so daß man diesem Effekt auch Rechnung tragen muß. Es ist aber auch möglich und in den meisten Fällen sinnvoll, auf dem Chip eine höhere Spannung zu erzeugen (bis ca. 20 V), so daß größere Schichtdicken aufgebracht und bei dem Schreib/Leseprozeß des Speicherbereiches B gepolt werden können. Insbesondere wird durch diese Maßnahme die Anfälligkeit der ferroelektrischen Speicherschicht gegenüber Störspannungen herabgesetzt.

Der Transfer der im nichtflüchtigen Speicherbereich B abgelegten Daten in den flüchtigen Speicherbereich A kann entweder automatisch bei Einschalten der Versorgungsspannung oder mittels eines RECALL Befehls softwaremäßig erfolgen. Dies wird erreicht durch zerstörendes Auslesen (destructive read out) in Form eines Schreibprozesses des Speicherelementes 13 im Speicherbereich B. Die je nach abgelegter Information dem Abtastund Auffrischverstärker zugeführte Ladung wird als binäre Information (0 oder 1) gewertet und dann anschließend im Rahmen eines normalen Refresh Zyklus im zugeordneten Speicherelement 7 des Speicherbereiches A durch die Aktivierung der Wortleitung 8b abgelegt. Die bei dem zerstörenden Auslesen freiwerdende Ladung beträgt bei anorganischen Ferroelektrika ca. 10 mC/cm2, so daß bei 10 µm2 Fläche eine Ladung von ca.$10^6$ Elektronen freigesetzt wird. Eine ähnliche Größe wird auch bei den Polymeren beobachtet. Die Größenordnung dieser LAdung ist durchaus vergleichbar mit der beim Auslesen des Ladungskondensators des Speicherbereiches A freiwerdenden Ladung, so daß die Detektion schaltungstechnisch nach dem Stand der Technik ohne weiteres möglich ist. Die nach dem zerstörenden Auslesen invertiert vorliegende Information wird mittels eines speziellen Schaltkreises direkt wieder in an den Speicherbereich B zurückgegeben. Andere in ferroelektrischen Speichern übliche Auslesemethoden z.B. mittels piezo- oder pyroelektrischer Aktivierung setzen dagegen erheblich weniger Ladungen frei (Faktor 100), so daß die Detektion zwar möglich aber schwierig ist.

## Patentansprüche

1. Nichtflüchtiger integrierter elektronischer Baustein, bei dem ein flüchtiger Halbleiterspeicherbaustein, gerannt: RAM, in schaltungstechnischem Verbund mit einem Permanentspeicher steht, dadurch gekennzeichnet, daß der Permanentspeicher (B) durch eine elektrisch polarisierbare vorzugsweise ferroelektrische Schicht (11) gebildet wird, die innerhalb eines monolithischen Bausteins in der dritten Dimension auf dem RAM (A) integriert und derart mit ihm verbunden ist, daß aufgrund eines STORE- bzw. RECALL-Befehls die im RAM-Speicherbereich (A) vorhandene Information permanent durch Polung ausgewählter Bereiche in der elektrisch polarisierbaren vorzugsweise ferroelektrischen Schicht (11) gespeichert bzw. ausgelesen und in den RAM-Speicherbereich (A) zurückübertragen wird.

2. Nichtflüchtiger elektronischer Speicherbaustein nach Anspruch 1, dadurch gekennzeichnet, daß auf dem RAM mit Wort- und Bitleitungen zur wahlweisen Adressierung der Speicherzellen eine elektrisch polarisierbare vorzugsweise ferroelektrische Schicht (11) aufgebracht ist, die an ihrer Ober- und Unterseite ebenfalls mit Wort- (12) bzw. Bitleitungen (9,15) in Form von Streifenelektroden versehen ist und das Streifenelektrodensystem an der Unterseite gleichzeitig das der Oberfläche zugewandte Wort- bzw. Bitleitungssystem (9) des RAM bildet oder elektrisch mit ihm verbunden ist, so daß jeder Halbleiterspeicherzelle (7) eine nichtflüchtige, ferroelektrische Speicherzelle (13) eindeutig zugeordnet ist.

3. Nichtflüchtiger elektronischer Speicherbaustein nach Anspruch 1, dadurch gekennzeichnet, daß die Oberfläche des Halbleiterspeichers mit den darauf angeordneten Wort- bzw. Bitleitungen (9) durch eine Planarisierungsschicht (10) eingeebnet ist, auf die die elektrisch polarisierbare vorzugsweise ferroelektrische Schicht (11) aufgebracht ist.

4. Nichtflüchtiger elektronischer Speicherbaustein nach Anspruch 1, dadurch gekennzeichnet, daß die elektrisch polarisierbare vorzugsweise ferroelektrische Schicht (11) unmittelbar auf die Halbleiteroberfläche aufgebracht ist und die Oberseite der elektrisch polarisierbaren vorzugsweise ferroelektrischen Schicht (11) mit einer Planarisierungsschicht (10) eingeebnet ist.

5. Nichtflüchtiger elektronischer Speicherbaustein nach Anspruch 2, dadurch gekennzeichnet, daß das der Oberfläche zugewandte Wort/Bitleitungssystem (9) über Kontaktstege (14) mit dem zusätzlich an der Unterseite der ferroelektrischen Schicht (11) aufgebrachten Streifenelektrodensystem (15) elektrisch verbunden ist.

6. Nichtflüchtiger elektronischer Speicherbaustein nach Anspruch 1 - 5, dadurch gekennzeichnet, daß die elektrisch polarisierbare vorzugsweise ferroelektrische Schicht (11) aus einem Polymer mit leicht polarisierbaren Atomen, insbesondere Polyolefine mit Fluoratomen oder aus einem Polymer mit stark polarisierbaren Endgruppen besteht.

7. Nichtflüchtiger elektronischer Speicherbaustein nach Anspruch 1 - 5, dadurch gekennzeichnet, daß die elektrisch polarisierbare vorzugsweise ferroelektrische Schicht (11) aus Polyvinylidenfluorid oder Polyvinylidencyanid oder Copolymerisaten von Polyvinylidenfluorid mit Polyvinyltrifluorid (PVF3) oder Trifluoräthylen oder Abmischungen mit Polymethylmethacrylat besteht.

## Claims

1. Non-volatile integrated electronic chip in which a volatile semiconductor memory chip, known as a RAM, is in circuit with a read-only memory, characterised in that the read-only memory (B) is formed from an electrically-polarizable, preferably ferroelectric, layer (11), that is integrated within a monolithic chip in the third dimension on the RAM (A) and connected thereto in such a way that as a result of a STORE or RECALL command, the information in the RAM memory area is respectively stored or read out permanently by polarization of selected areas in the electrically-polarizable layer (11) and transferred again into the RAM memory area (A).

2. Non-volatile electronic chip according to claim 1, characterised in that an electrically-polarizable, preferably ferroelectric, layer (11) is applied to the RAM with word and bit lines for selective addressing of the memory locations, said layer also having word lines (12) or bit lines (9, 15) on its upper side and underside in the form of strip electrodes, and that the strip electrode system on the underside at the same time forms, or is electrically connected to, the word and bit line system (9) of the RAM facing the surface, so that a non-volatile, ferroelectric memory location (13) is unambiguously allocated to each semiconductor memory location (7).

3. Non-volatile electronic chip according to claim 1, characterised in that the surface of the semiconductor memory with its arrangement of word and bit lines (9) is made level by means of a planar layer (10) onto which the electrically-polarizable, preferably ferroelectric, layer (11) is deposited.

4. Non-volatile electronic chip according to claim 1, characterised in that the electrically-polarizable, preferably ferroelectric, layer (11) is applied directly onto the semiconductor surface and the upper side of the electrically-polarizable, preferably ferroelectric, layer (11) is made level by means of a planar layer (10).

5. Non-volatile electronic chip according to claim 2, characterised in that the word/bit line system (9) facing the surface is electrically connected via contact webs (14) to the strip electrode system (15) that is additionally deposited on to the underside of the ferroelectric layer (11).

6. Non-volatile electronic chip according to claims 1 to 5, characterised in that the electrically-polarizable, preferably ferroelectric, layer (11) consists of a polymer with weakly-polarizable atoms, particularly polyolefine with fluoro-atoms, or of a polymer with strongly-polarizable end groups.

7. Non-volatile electronic chip according to claims 1 to 5, characterised in that the electrically-polarizable, preferably ferroelectric, layer (11) consists of polyvinylidenefluoride or polyvinylidenecyanide or copolymers of polyvinylidenefluoride with polyvinyltrifluoride (PVF3) or trifluoroethylenes or compounds

with polymethylmethacrylate.

## Revendications

1. Circuit électronique intégré non volatile qui comprend un circuit de mémoire à semi-conducteurs volatile, appelé RAM, relié à une mémoire rémanente au moyen de la technique de commutation, caractérisé en ce que la mémoire rémanente (B) est formée par une couche polarisable électriquement et de préférence ferroélectrique (11) qui est intégrée sur la RAM (A) dans la troisième dimension à l'intérieur d'un circuit monolithique et qui est reliée à la RAM de telle manière qu'en lançant une commande STORE ou RECALL, les informations qui se trouvent dans la zone de mémoire de la RAM (A) sont enregistrées ou lues en permanence par polarisation des zones sélectionnées dans la couche polarisable électriquement et de préférence ferroélectrique (11) et retransférées dans la zone de mémoire de la RAM (A).

2. Circuit électronique de mémoire non volatile suivant la revendication 1, caractérisé en ce que sur la RAM qui possède des lignes de mots et de bits pour l'adressage sélectif des cellules mémoires est appliquée une couche polarisable électriquement (11), de préférence ferroélectrique, qui est également pourvue de lignes de mots (12) ou de bits (9, 15) sous forme d'électrodes de grille sur ses faces supérieure et inférieure, et que le système d'électrodes de grille sur la face inférieure forme en même temps le système de lignes de mots ou de bits (9) de la RAM tourné vers la face supérieure ou est lié électriquement à ce système de lignes, de sorte qu'une cellule mémoire ferroélectrique non volatile (13) est affectée de façon univoque à chaque cellule mémoire à semi-conducteurs (7).

3. Circuit électronique de mémoire non volatile suivant la revendication 1, caractérisé en ce que la surface de la mémoire à semi-conducteurs et les lignes de mots ou de bits (9) disposées sur celle-ci sont égalisées par une couche de planarisation (10) sur laquelle est appliquée la couche polarisable électriquement, de préférence ferroélectrique (11).

4. Circuit électronique de mémoire non volatile suivant la revendication 1, caractérisé en ce que la couche polarisable électriquement, de préférence ferroélectrique (11) est directement appliquée sur la surface des semi-conducteurs et que la face supérieure de la couche polarisable électriquement, de préférence ferroélectrique (11) est égalisée à l'aide d'une couche de planarisation (10).

5. Circuit électronique de mémoire non volatile suivant la revendication 2, caractérisé en ce que le système de lignes de mots/bits (9) tourné vers la face supérieure est relié électriquement au système d'électrodes de grille (15) appliqué en plus sur la face inférieure de la couche ferroélectrique (11) par l'intermédiaire de barrettes de contact (14).

6. Circuit électronique de mémoire non volatile suivant les revendications 1 - 5, caractérisé en ce que la couche polarisable électriquement, de préférence ferroélectrique (11) se compose d'un polymère à atomes faiblement polarisables, et plus particulièrement de polyoléfines à atomes de fluor, ou d'un polymère à groupes terminaux fortement polarisables.

7. Circuit électronique de mémoire non volatile suivant les revendications 1 - 5, caractérisé en ce que la couche polarisable électriquement, de préférence ferroélectrique (11) se compose de fluorure de polyvinylidène ou de cyanure de polyvinylidène ou de copolymérisats de fluorure de polyvinylidène et de trifluorure de polyvinyle (PVF3) ou de trifluoréthylène ou de mélanges avec du polyméthacrylate de méthyle.

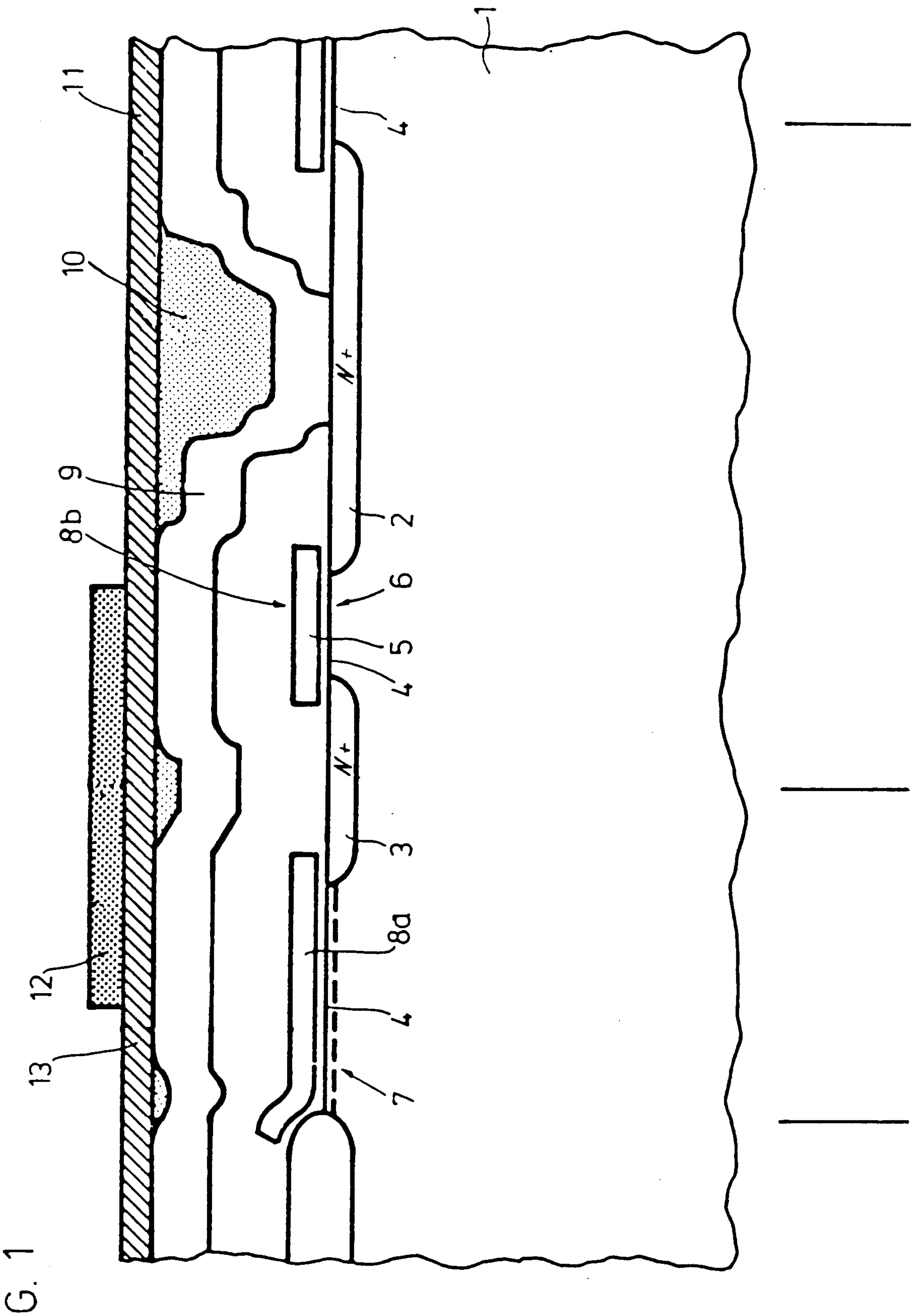


FIG. 1

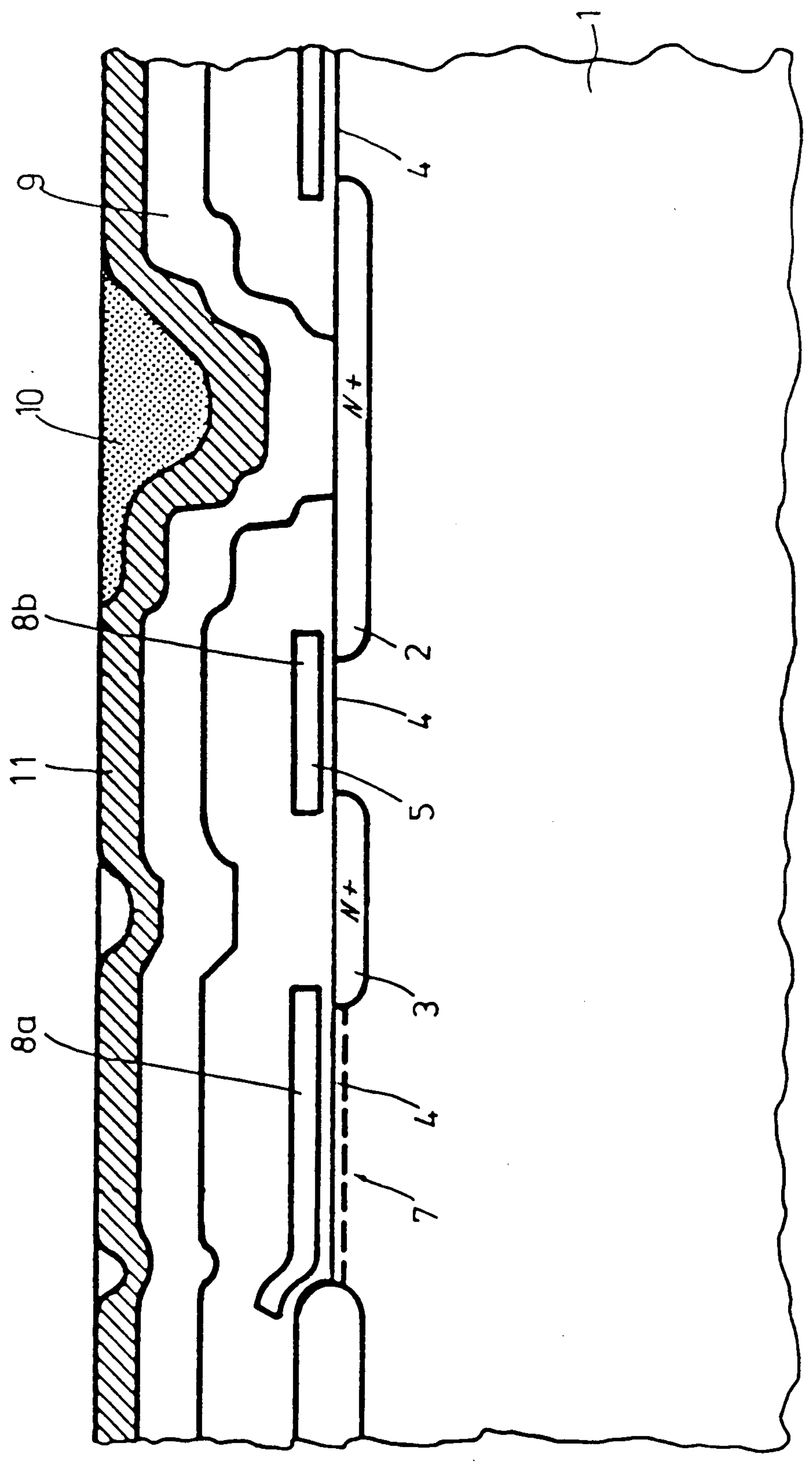


FIG. 2

FIG. 3

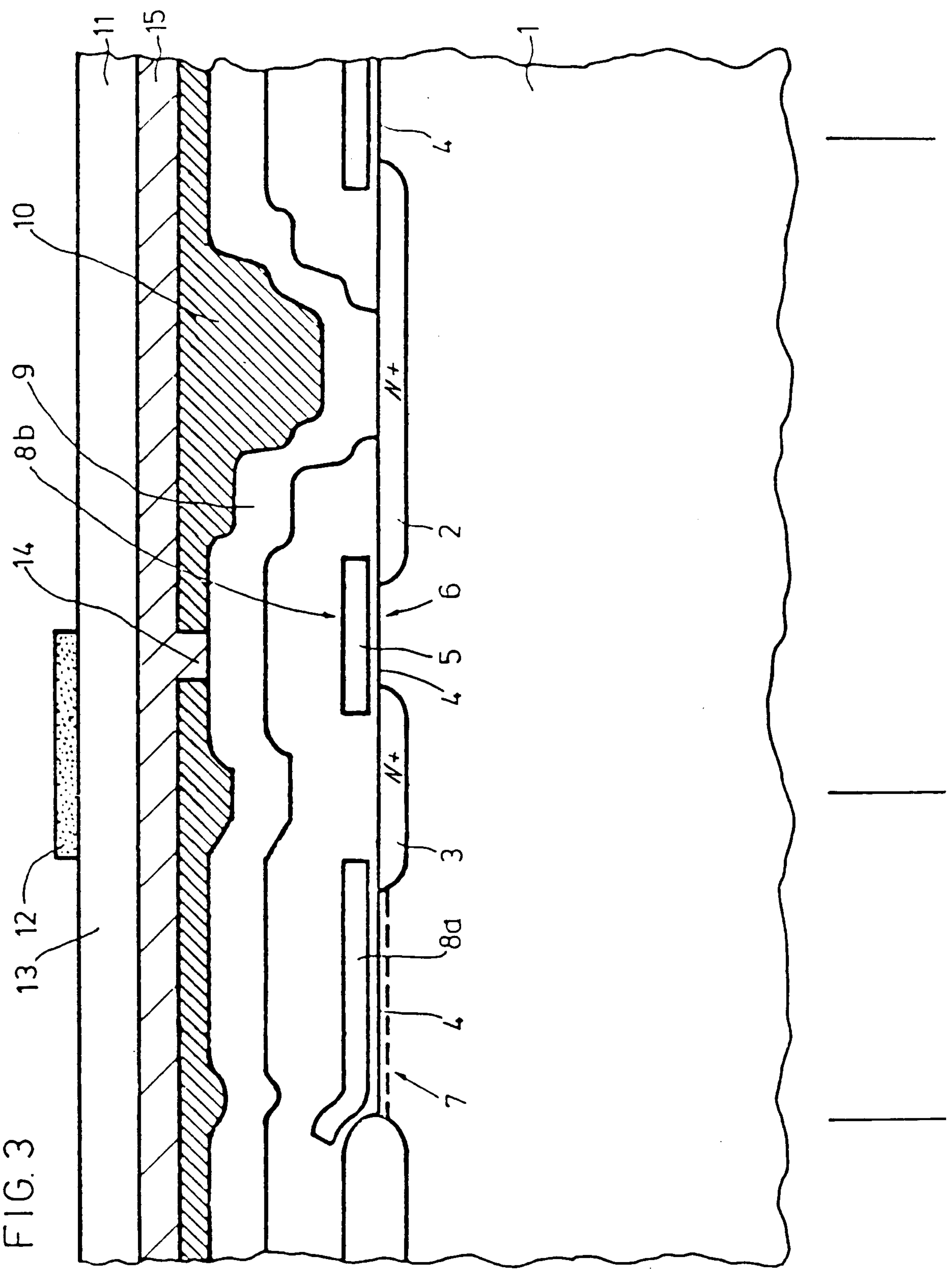

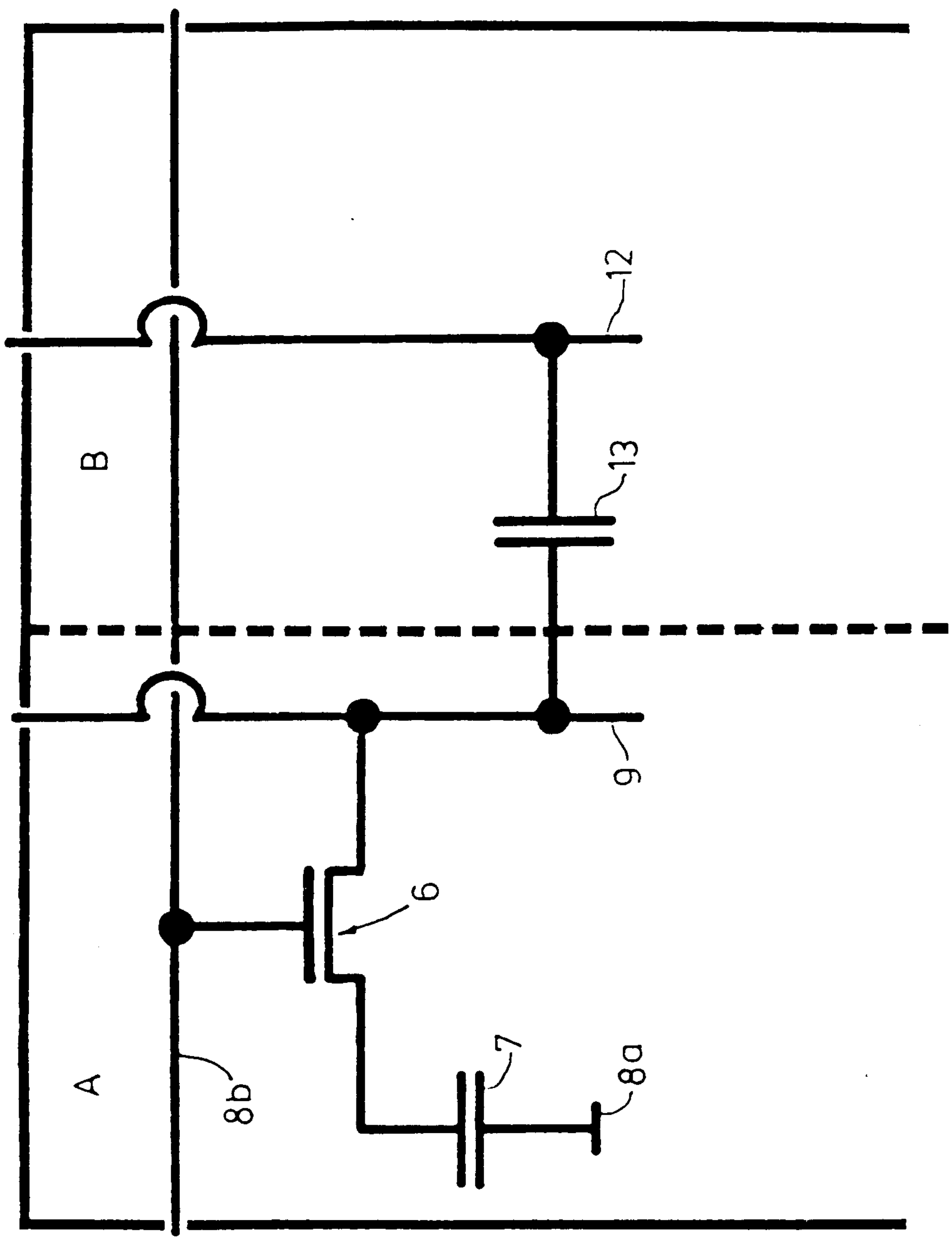


FIG. 4